# EUROPEAN PATENT APPLICATION

(11) **EP 4 539 650 A1**
(43) Date of publication of application: **16.04.2025**
(21) Application number: 23934307.2
(22) Date of filing: 10.11.2023
(51) Int. Cl.: H10N 60/80, H10N 60/01, H10N 60/82

(54) **QUANTUM BIT COMPONENT AND PREPARATION METHOD THEREFOR, AND QUANTUM CHIP AND CHIP PREPARATION SYSTEM**

(30) Priority: 29.08.2023 CN 202311114907
(71) Applicant: TENCENT TECHNOLOGY (SHENZHEN) COMPANY LIMITED, Shenzhen, Guangdong 518057 (CN)
(72) Inventor: LI, Dengfeng, Shenzhen Guangdong 518057 (CN); DAI, Maochun, Shenzhen Guangdong 518057 (CN); HU, Jingjing, Shenzhen Guangdong 518057 (CN); ZOU, Chenji, Shenzhen Guangdong 518057 (CN); AN, Shuoming, Shenzhen Guangdong 518057 (CN)
(74) Representative: Reddie & Grose LLP
(86) International application number: PCT/CN2023/130974
(87) International publication number: WO 2025/043887

(57) **Abstract**

A qubit assembly and a production method thereof, a quantum chip, and a chip production system are provided, which relate to the field of micro-nanofabrication technologies. The production method includes: preparing an underlying film of a qubit assembly on a substrate (S510); preparing an underlying circuit based on the underlying film (S520), a surface of the underlying circuit having a nitride passivation layer; and preparing, on the substrate, a qubit connected to the underlying circuit (S530), to obtain the qubit assembly.

## Description

### RELATED APPLICATION

This application claims priority to Chinese Patent Application No. 202311114907.6, filed on August 29, 2023 and entitled "QUBIT ASSEMBLY AND PRODUCTION METHOD THEREOF, QUANTUM CHIP, AND CHIP PRODUCTION SYSTEM", which is incorporated herein by reference in its entirety.

### FIELD OF THE TECHNOLOGY

This application relates to the field of micro-nanofabrication technologies, and in particular, to a qubit assembly and a production method thereof, a quantum chip, and a chip production system.

### BACKGROUND OF THE DISCLOSURE

How to extend coherence of a quantum system is an important problem for a quantum computer. The impact of a superconducting material on the coherence is mainly a TLS loss of the material. The TLS loss mainly originates from an oxide layer on a surface of the material.

In the related art, the TLS loss may be reduced by using a solution such as replacing a commonly used aluminum film with a niobium or tantalum film having a thinner oxide layer, or using hydrofluoric acid to remove the oxide layer and then placing the material in a refrigerator as soon as possible to vacuum and reduce a temperature.

### SUMMARY

Embodiments of this application provide a qubit assembly and a production method thereof, a quantum chip, and a chip production system, which can improve coherence of a qubit. The technical solutions are as follows.

According to an aspect, a qubit assembly is provided. The qubit assembly includes:
an underlying circuit and a qubit,
where a surface of the underlying circuit is provided with a nitride passivation layer.

According to another aspect, a qubit assembly production method is provided. The method includes:
producing an underlying film of a qubit assembly on a substrate;
producing an underlying circuit based on the underlying film, a surface of the underlying circuit being provided with a nitride passivation layer; and
producing, on the substrate, a qubit connected to the underlying circuit, to obtain the qubit assembly.

According to still another aspect, a quantum chip is provided. The quantum chip includes the qubit assembly as described above.

According to yet another aspect, a chip production system is provided. The system includes: an evaporation machine, a resist coating machine, a photoetching machine, and an etching machine, where
the evaporation machine is configured to produce an underlying film of a qubit assembly on a substrate;
the resist coating machine, the photoetching machine, and the etching machine are configured to produce an underlying circuit based on the underlying film, a surface of the underlying circuit being provided with a nitride passivation layer; and
the evaporation machine, the resist coating machine, the photoetching machine, and the etching machine are further configured to produce, on the substrate, a qubit connected to the underlying circuit, to obtain the qubit assembly.

In some embodiments, the system further includes a nitridation treatment device configured to perform nitridation treatment on a first product to obtain the underlying circuit, the first product being obtained by performing, through the resist coating machine and the photoetching machine, exposing and etching on the underlying film according to a pattern of the underlying circuit.

In some embodiments, the nitridation treatment device includes a nitridation cavity configured to place the first product in a nitrogen environment and heat the first product to a first temperature.

In some embodiments, the first temperature is 800 degrees Celsius.

In some embodiments, the nitridation treatment device includes a plasma cleaning machine or a plasma etching machine. The plasma cleaning machine or the plasma etching machine is configured to place the first product in a nitrogen plasma implantation environment and heat the first product to a second temperature for a specified duration.

In some embodiments, the second temperature is 300 degrees Celsius and the specific duration is 10 minutes.

In some embodiments, the nitridation treatment device includes an evaporation machine configured to evaporate a nitride passivation layer on the first product.

In some embodiments, the system further includes:
a cleaning machine, configured to rinse a surface of the first product, to remove an oxide layer on the surface of the first product.

In some embodiments, the system further includes a nitridation treatment device configured to perform nitridation treatment on the underlying film; and
the resist coating machine, the photoetching machine, and the etching machine are configured to perform exposing and etching on the underlying film according to a pattern of the underlying circuit to obtain a first product, and perform nitridation treatment on the first product to obtain the underlying circuit.

The beneficial effects brought by the technical solutions provided in the embodiments of this application at least include: In a process of producing the qubit assembly, the nitride passivation layer is produced on the surface of the underlying circuit. Since the nitride passivation layer can effectively avoid oxidation of a film surface, the foregoing qubit assembly can reduce generation of a TLS loss and extend coherence time of the quantum chip. That is to say, the foregoing solutions can be used to produce a superconducting quantum chip with long decoherence, thereby improving decoherence performance of the superconducting quantum chip.

### BRIEF DESCRIPTION OF THE DRAWINGS

FIG. 1 is a flowchart of preparing a superconducting quantum chip according to this application.
FIG. 2 is a schematic diagram of a structure of a qubit assembly according to an embodiment of this application.
FIG. 3 is a schematic diagram of a structure of another qubit assembly according to an embodiment of this application.
FIG. 4 is a schematic diagram of a structure of a quantum chip according to an embodiment of this application.
FIG. 5 is a flowchart of a qubit assembly production method according to an exemplary embodiment of this application.
FIG. 6 is a flowchart of a qubit assembly production method according to an embodiment of this application.
FIG. 7 is a schematic diagram of coating a nitride passivation layer on an underlying film according to this application.
FIG. 8 is a schematic diagram of an oxide layer on a side wall of an etching groove according to this application.
FIG. 9 is a flowchart of a qubit assembly production method according to an embodiment of this application.
FIG. 10 is a schematic diagram of nitrogen ion implantation according to an exemplary embodiment of this application.
FIG. 11 is a flowchart of a qubit assembly production method according to an exemplary embodiment of this application.
FIG. 12 is a flowchart of preparing a qubit assembly involved in the embodiment shown in FIG. 11.
FIG. 13 is a schematic diagram of a chip production system according to an exemplary embodiment of this application.
FIG. 14 is a schematic diagram of a solution application scenario according to an embodiment of this application.

### DESCRIPTION OF EMBODIMENTS

Qubit: In quantum informatics, it is a measurement unit of quantum information. Unlike a classical bit can only be in one of a state of 0 or a state of 1, the qubit can be in both the state of 0 and the state of 1, that is, a quantum superposition state of 0 and 1.

Josephson Junction: It is also referred to as a superconducting tunnel junction. It is a structure generally including two superconductor clips with a very thin barrier layer (a thickness ≤ a coherence length of a Cooper electron pair), for example, an S (superconductor)-I (semiconductor or insulator)-S (superconductor) structure, SIS for short. In the Josephson junction, a superconducting electron may pass through a semiconductor or an insulator film from one side to the other side through a tunneling effect.

A production process of the Josephson junction is as follows: A structural pattern (also referred to as a Dolan bridge structure) including an undercut is formed on a two-layer electron beam photoresist on a surface of a substrate by using an electron beam exposure method. Then, a junction region is produced by using a double-tilt evaporation method in which a superconducting metal film is first obliquely evaporated, oxidized, to form an oxide insulation layer, and then a superconducting metal film is vertically evaporated.

TLS loss: It is a phenomenon in which a two level system (TLS) in a superconducting quantum chip material interacts with a microwave in the quantum chip, shortening coherence time of a qubit.

Exposure: It is a micro-nanofabrication technology and mainly involves ultraviolet photoetching, that is, coating a photoresist on a surface of a substrate sample, then irradiating ultraviolet light through a mask to the surface of the substrate, using a photochemical reaction to change a property of a part of the photoresist irradiated by the light, and then dissolving a region reacted with the light into a specific solution to achieve a purpose of making a specific pattern on the substrate.

Etching: It is a micromachining process in which a dry method and a wet method (a liquid) are used to etch metal or another material to form a required structure.

Undercut: In a double-layer resist process, a window is opened by using a photoresist of an upper resist after exposure and development, and an underlying resist continues to be etched in a developer and expands laterally to form a structure that is narrow at the top and wide at the bottom.

Resist removing solution: It is an organic solvent that can remove a residual photoresist that has not reacted with light after a sample is exposed and developed.

A quantum computer receives increasing attention due to a more powerful computing capability than a traditional computer. A quantum computing solution based on a superconducting system is more appealing due to good scalability and compatibility with existing semiconductor technologies.

The powerful computing capability of quantum computation mainly benefits from a quantum superposition state. However, the superposition state based on quantum mechanics is easily interfered by an environment and is depolarized to a classical state. Time used for depolarization is referred to as relaxation time. A length of the relaxation time directly affects the computing capability of the quantum computer. Therefore, how to extend coherence of a quantum system becomes an important problem for the quantum computer.

The impact of a superconducting material on the coherence is mainly a TLS loss of the material. The TLS loss mainly originates from an oxide layer on a surface of the material. To reduce the TLS loss, some solutions are generally used, such as replacing a commonly used aluminum film with a niobium or tantalum film having a thinner oxide layer, or using hydrofluoric acid to remove the oxide layer and then placing the material in a refrigerator as soon as possible to vacuum and reduce a temperature.

A superconducting quantum chip is one of important carriers that can be used to study quantum computation, and generally includes a substrate, a waveguide film (also commonly referred to as a large circuit structure), a qubit structure, other structures, and the like.

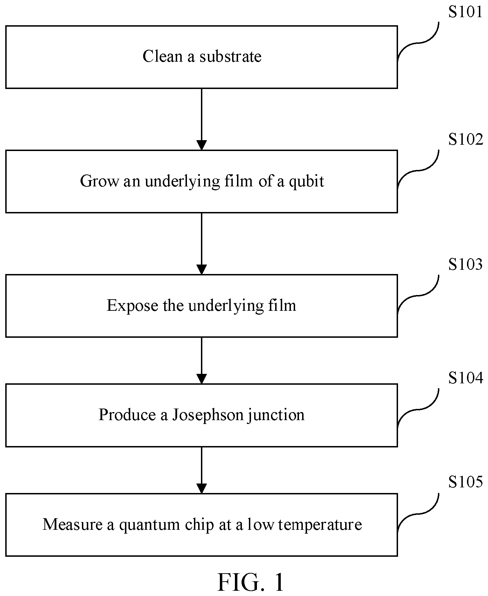

FIG. 1 is a flowchart of preparing a superconducting quantum chip according to this application. As shown in FIG. 1, the method may include the following operations.

Operation 101: Clean a substrate.

The substrate is mainly sapphire or a silicon wafer. An objective of cleaning is mainly to remove organic impurities on a surface of the substrate. In addition, an operation of cleaning the silicon wafer is also to remove a natural oxide layer on the surface of the silicon wafer.

Operation 102: Grow an underlying film of a qubit on the substrate.

An aluminum film, a niobium film, or a tantalum film may be selected as the underlying film. The underlying film is mainly configured for preparing a large-sized structure such as a transmission line, a resonant cavity, and a capacitor of a quantum chip.

The resonant cavity and the capacitor are also main sources of a TLS loss due to distribution of a large number of microwave fields.

Operation 103: Produce a transmission line, a resonant cavity, a capacitor, and the like by exposing the underlying film.

Operation 104: Produce a Josephson junction by using a tilt coating manner to form the qubit.

Operation 105: Perform measurement on the qubit at a low temperature.

In the operations of preparing the quantum chip, subsequent exposure and other operations are required after underlying coating in operation 102. Therefore, the underlying film is oxidized in the air, resulting in the TLS loss of the material, further affecting the coherence of the qubit.

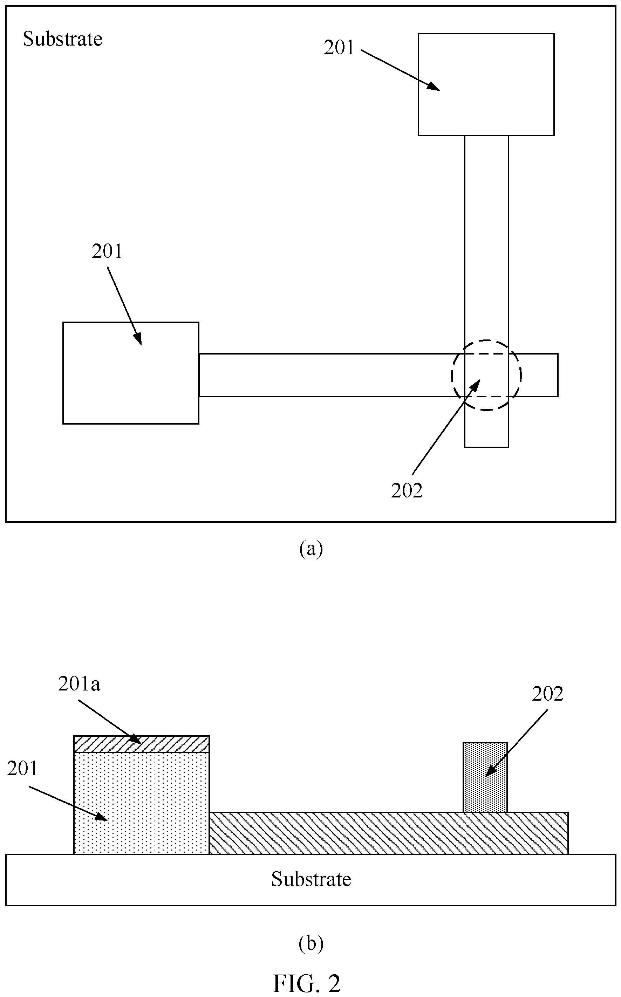

FIG. 2 is a schematic diagram of a structure of a qubit assembly according to an embodiment of this application. As shown in FIG. 2, a part (a) in FIG. 2 is a top view of the qubit assembly, and a part (b) in FIG. 2 is a cross-sectional view of the qubit assembly. The qubit assembly includes the following parts:
an underlying circuit 201 and a qubit 202.

A surface of the underlying circuit 201 is provided with a nitride passivation layer 201a.

That is to say, the qubit assembly includes the underlying circuit 201 and the qubit 202, and the surface of the underlying circuit 201 is provided a layered structure of the nitride passivation layer 201a thereon.

The nitride passivation layer 201a may correspond to a material of the underlying circuit 201. For example, a material of the underlying circuit 201 is a metal of niobium, and the nitride passivation layer 201a is a niobium nitride passivation layer.

The nitride passivation layer 201a may not correspond to the material of the underlying circuit 201. The nitride passivation layer 201a may be evaporated by coating. For example, the material of the underlying circuit 201 is a metal of aluminum, and then a nitride passivation layer 201a of niobium nitride or tantalum nitride is evaporated on the underlying circuit 201.

In conclusion, the qubit assembly shown in this embodiment of this application includes the underlying circuit 201 and the qubit 202, and the surface of the underlying circuit 201 is provided with the nitride passivation layer 201a thereon. The nitride passivation layer 201a can avoid oxidation of the surface of the underlying circuit 201, thereby reducing generation of the TLS loss and extending the coherence time of the qubit.

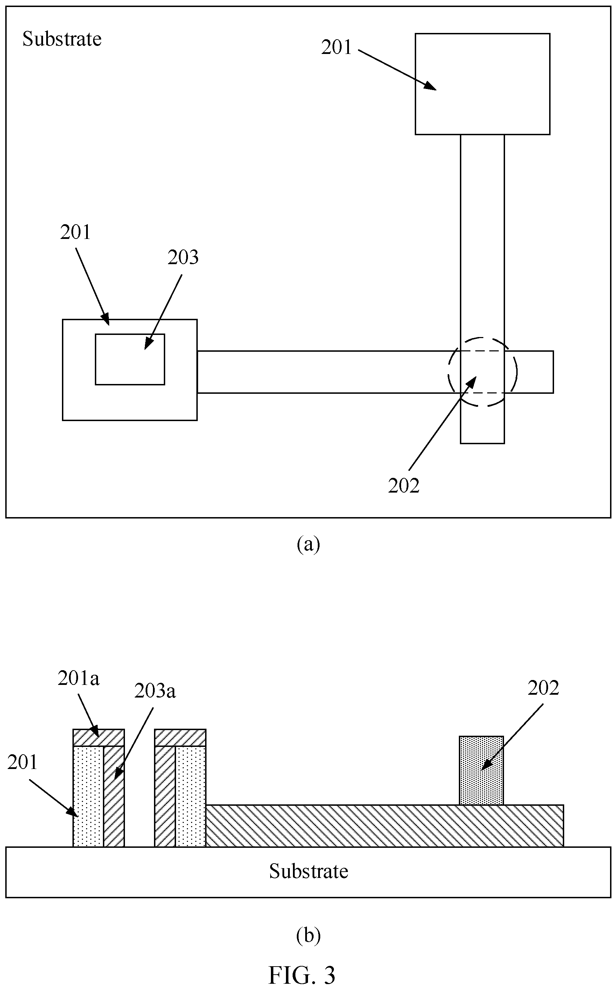

Based on the embodiment shown in FIG. 2, FIG. 3 is a schematic diagram of a structure of another qubit assembly according to an embodiment of this application. As shown in FIG. 3, a part (a) in FIG. 3 is a top view of the qubit assembly, and a part (b) in FIG. 3 is a cross-sectional view of the qubit assembly. The qubit assembly includes the following parts:
an underlying circuit 201 and a qubit 202.

A surface of the underlying circuit 201 is provided with a nitride passivation layer 201a.

As shown in FIG. 3, in a possible implementation, a side surface of an etching groove 203 of the underlying circuit is provided with a nitride passivation layer 203a thereon.

After performing exposing and etching on the underlying film according to a pattern of the underlying circuit, since an inner wall of the etching groove 203 is not covered by a passivation layer, the inner wall of the etching groove 203 is still oxidized. Therefore, the nitride passivation layer on the inner wall of the etching groove 203 can further avoid oxidation of the side wall of the etching groove.

In view of this, this embodiment of this application is based on the embodiment shown in FIG. 2. The side surface of the etching groove 203 of the underlying circuit is also provided with a layered structure of the nitride passivation layer 203a thereon.

That is to say, the qubit assembly includes the underlying circuit 201 and the qubit 202, the surface of the underlying circuit 201 is provide with the layered structure of the nitride passivation layer 201a thereon, and the side surface of the etching groove 203 of the underlying circuit is provided with the layered structure of the nitride passivation layer 203a thereon.

The nitride passivation layer 203a may correspond to a material of the underlying circuit 203. For example, a material of the underlying circuit 203 is a metal of tantalum, and the nitride passivation layer 201a is a tantalum nitride passivation layer.

The nitride passivation layer 203a may not correspond to the material of the underlying circuit 201. The nitride passivation layer 203a may be evaporated by coating. For example, the material of the underlying circuit 201 is a metal of aluminum, and then a nitride passivation layer 203a of niobium nitride or tantalum nitride is evaporated on the side surface of the etching groove 203.

The qubit assembly shown in this embodiment of this application includes the underlying circuit 201 and the qubit 202, the surface of the underlying circuit 201 is provided with the nitride passivation layer 201a, and the inner wall of the etching groove 203 is provided with the nitride passivation layer 203a. The nitride passivation layer 201a and the nitride passivation layer 203a can avoid oxidation of the surface of the underlying circuit 201 and the inner wall of the etching groove 203, reduce the generation of the TLS loss, and extend the coherence time of the qubit.

In a possible implementation, the material of the underlying circuit is a metal selected from niobium, tantalum, or aluminum, and the nitride passivation layer is a niobium nitride passivation layer, a tantalum nitride passivation layer, or an aluminum nitride passivation layer.

In this embodiment of this application, the material of the underlying circuit may be a superconducting material that can be nitrided. For example, the material of the underlying circuit is a metal selected from aluminum, niobium, or tantalum. Correspondingly, the foregoing nitride passivation layer may be an aluminum nitride passivation layer, a niobium nitride passivation layer, or a tantalum nitride passivation layer.

For example, when the material of the underlying circuit is a metal of aluminum, the nitride passivation layer may be an aluminum nitride passivation layer; or when the material of the underlying circuit is a metal of niobium, the nitride passivation layer may be a niobium nitride passivation layer; or when the material of the underlying circuit is a metal of tantalum, the nitride passivation layer may be a tantalum nitride passivation layer.

Alternatively, the material of the underlying circuit may not correspond to a material of the nitride passivation layer. For example, when the material of the underlying circuit is a metal of aluminum, the nitride passivation layer may be a niobium nitride passivation layer or a tantalum nitride passivation layer; or when the material of the underlying circuit is a metal of niobium, the nitride passivation layer may be an aluminum nitride passivation layer or a tantalum nitride passivation layer; or when the material of the underlying circuit is a metal of tantalum, the nitride passivation layer may be an aluminum nitride passivation layer or a niobium nitride passivation layer.

A superconducting material that can be nitrided, such as a metal of aluminum, niobium, or tantalum, may be selected for the underlying circuit. In addition to facilitating generation of the nitride passivation layer on the surface of the underlying circuit or the inner wall of the etching groove, the nitride passivation layer can suppress the oxidation of the surface of the underlying circuit or the inner wall of the etching groove, reduce the generation of the TLS loss, and extend the coherence time of the qubit. Universality of the technical solution can further be improved, and the technical solution can be widely used for a superconducting film such as an aluminum film, a niobium film, or a tantalum film.

In a possible implementation, the underlying circuit includes at least one of the following structures: a resonant cavity, a capacitor, or a transmission line.

In the qubit assembly, the resonant cavity and the capacitor are main sources of the TLS loss due to distribution of a large number of microwave fields. In addition, the transmission line is also a structure with a large size, and also brings a specific TLS loss.

In view of this, in this embodiment of this application, in the underlying circuit including at least one structure of the resonator, the capacitor, or the transmission line, the surface of the underlying circuit is covered by a nitride passivation layer, to suppress formation of an oxide layer on a surface of the structure such as the resonator, the capacitor, or the transmission line, thereby effectively reducing the generation of the TLS loss and extending the coherence time of the qubit.

In a possible implementation, a thickness of the nitride passivation layer ranges from 5 nanometers to 10 nanometers.

In this embodiment of this application, thicknesses of the nitride passivation layers on the surface of the underlying circuit and the side surface of the etching groove may be controlled to range from 5 nanometers to 10 nanometers. Oxidation phenomena on the surface of the underlying circuit and the side surface of the etching groove can be suppressed. In addition, the thickness of the nitride passivation layer can be prevented from being excessively large and affecting performance of the qubit assembly.

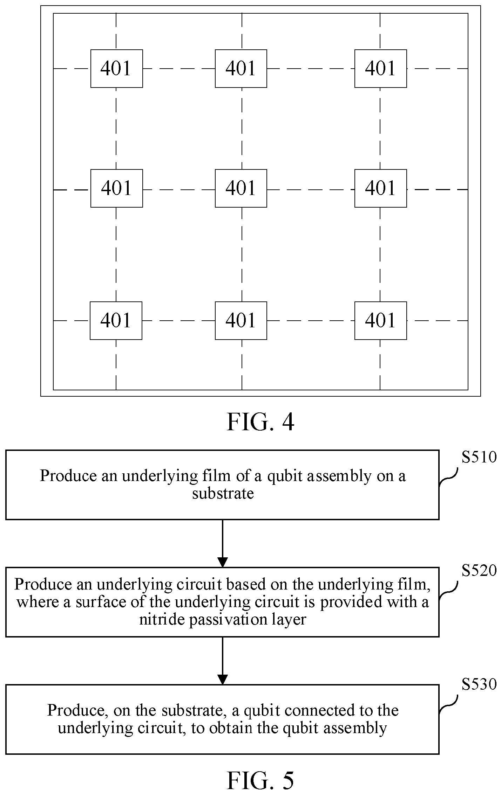

FIG. 4 is a schematic diagram of a structure of a quantum chip according to an embodiment of this application. As shown in FIG. 4, the quantum chip provided in this embodiment of this application includes one or more qubit assemblies 401. The qubit assembly 401 may be the foregoing qubit assembly in FIG. 2 or FIG. 3.

FIG. 5 is a flowchart of a qubit assembly production method according to an exemplary embodiment of this application. This method may produce the qubit assembly shown in FIG. 2 or FIG. 3. As shown in FIG. 5, the method may include the following operations.

Operation 510: Produce an underlying film of a qubit assembly on a substrate.

In this embodiment of this application, the underlying film may be first produced on the substrate. For example, a superconducting material is evaporated on the substrate by using an evaporation machine, to produce/grow the underlying film on the substrate.

A superconducting material that can be nitrided, such as an aluminum film, a niobium film, or a tantalum film, may be selected for the underlying film, to facilitate subsequent generation of the nitride passivation layer on the surface of the underlying circuit, to suppress oxidation of the surface of the underlying circuit or the inner wall of the etching groove, reduce the generation of the TLS loss, and extend the coherence time of the qubit.

Before the underlying film of the qubit assembly is produced on the substrate, the substrate may be cleaned to remove organic impurities and an oxide layer on the substrate.

Operation 520: Produce an underlying circuit based on the underlying film, a surface of the underlying circuit having a nitride passivation layer.

In this embodiment of this application, operations such as photoresist spin-coating, exposure, photoresist cleaning, and etching of the underlying film may be performed on the underlying film according to a pattern/mask of the underlying circuit, to produce the underlying circuit on the substrate. In this process, nitridation treatment is further performed on the underlying film, so that the surface of the underlying circuit can be provided with a nitride passivation layer. The nitride passivation layer can avoid oxidation of the surface of the underlying circuit, reduce the generation of the TLS loss, and extend the coherence time of the qubit.

A niobium nitride passivation layer, a tantalum nitride passivation layer, or an aluminum nitride passivation layer may be selected as the nitride passivation layer.

Operation 530: Produce, on the substrate, a qubit connected to the underlying circuit, to obtain the qubit assembly.

After the underlying circuit having the nitride passivation layer is produced, the qubit connected to the underlying circuit may be further produced. Because the surface of the underlying circuit has the nitride passivation layer, in a subsequent production process, the oxidation phenomenon on the surface of the underlying circuit is suppressed, and a finally obtained qubit assembly can have better coherence.

In conclusion, according to the solution shown in this embodiment of this application, in the produced qubit assembly, the surface of the underlying circuit is provided with the nitride passivation layer. Since the nitride passivation layer can effectively avoid oxidation of a film surface, the foregoing qubit assembly can reduce the generation of the TLS loss and extend the coherence time of the quantum chip. That is to say, the foregoing solution can be used for preparing a superconducting quantum chip with long decoherence, thereby improving decoherence performance of the superconducting quantum chip.

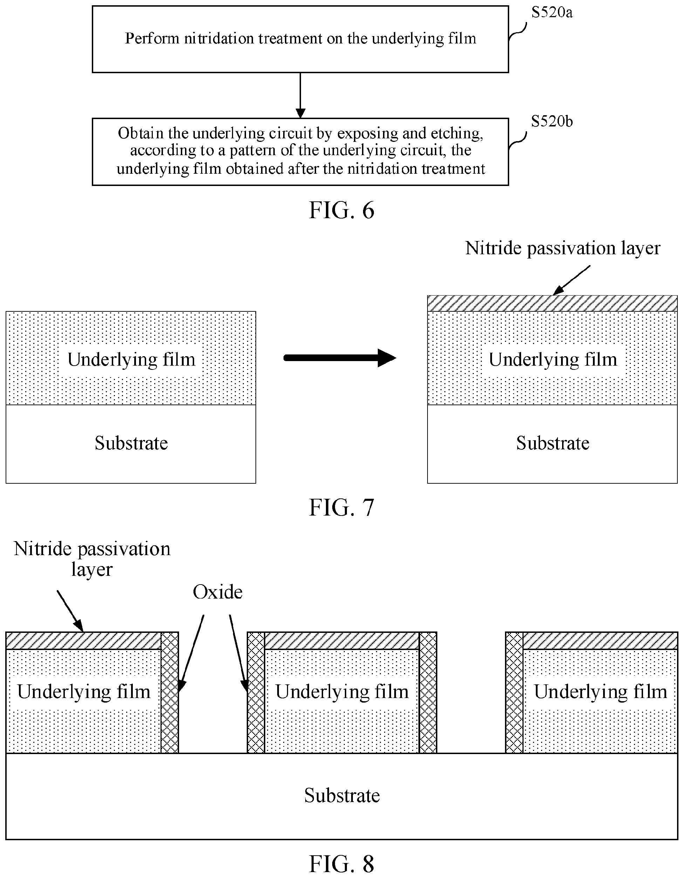

Based on the embodiment shown in FIG. 5, FIG. 6 is a flowchart of a qubit assembly production method according to an embodiment of this application. As shown in FIG. 6, Operation 520 in the embodiment shown in FIG. 5 may be implemented as Operation 520a and Operation 520b.

Operation 520a: Perform nitridation treatment on the underlying film.

In a possible implementation, the nitridation treatment method shown in this embodiment of this application may include the following operations.

First, an underlying film is grown on a substrate. For example, the underlying film may be grown on the substrate by evaporation.

An aluminum film, a niobium film, or a tantalum film may be selected as the underlying film, and a coating thickness may range from 100 nm to 200 nm. Magnetron sputtering may be preferentially selected as a coating method.

Then, a nitride passivation layer may be grown on the underlying film in situ.

Since aluminum nitride has a piezoelectric effect and affects subsequent sample measurement, niobium nitride or tantalum nitride may be selected for the passivation layer, and a thickness of the passivation layer ranges from 5 nm to 10 nm.

In a possible implementation, the nitridation treatment method shown in this embodiment of this application may further include the following operations.
(1) Place the underlying film in a nitrogen environment and heat the underlying film to a first temperature.

That is to say, the nitridation treatment method is to place the underlying film in the nitrogen environment, and apply the first temperature to the underlying film, so that nitrogen reacts with the underlying film to form a nitride, to form a nitride passivation layer that prevents oxidation.

In a possible implementation, the first temperature is 800 degrees Celsius.

In some embodiments, the temperature applied to the underlying film is generally 800 degrees Celsius or higher. In this embodiment of this application, 800 degrees Celsius may be selected.

(2) Place the underlying film in a nitrogen plasma implantation environment and heat the underlying film to a second temperature for a specified duration.

In some embodiments, to increase the reaction efficiency, another nitridation treatment method is to directly use nitrogen plasma, and a device such as a plasma resist removing machine or a plasma etching machine may be selected.

To improve the implantation efficiency, a specific temperature may also be appropriately applied to the underlying film. In this case, a nitride of a few nanometers may be generated, to form a nitride passivation layer that prevents oxidation.

In a possible implementation, the second temperature is 300 degrees Celsius and the specified duration is 10 minutes.

In some embodiments, in this case, the temperature applied to the underlying film may be heated to 300 degrees Celsius, and nitrogen plasma implantation time may be 10 minutes.

In conclusion, in the solution shown in this embodiment of this application, since a TLS loss of the nitride is lower than that of the oxide, the oxidation of the underlying film can be prevented after the nitride is grown, and the TLS loss can be reduced.

Operation 520b: Obtain the underlying circuit by exposing and etching, according to a pattern of the underlying circuit, the underlying film obtained after the nitridation treatment.

In this embodiment of this application, after the nitridation treatment is performed on the underlying film based on Operation 520a, operations such as photoresist spin-coating, exposure, photoresist cleaning, and etching of the underlying film may be performed on the underlying film according to the pattern/mask of the underlying circuit, to produce the underlying circuit on the substrate.

During production of the underlying circuit, the nitridation treatment is further performed on the underlying film. Therefore, the surface of the underlying circuit can have a nitride passivation layer, the oxidation phenomenon on the surface of the underlying circuit can be suppressed, and the finally obtained qubit assembly can have better coherence.

In the solution shown in this embodiment of this application, the finally obtained qubit assembly may be the foregoing qubit assembly in FIG. 2. As shown in FIG. 2, the surface of the underlying circuit 201 has the nitride passivation layer 201a. The nitride passivation layer 201a can avoid oxidation of the surface of the underlying circuit, reduce the generation of the TLS loss, extend the coherence time of the qubit, and improve the coherence of the qubit.

FIG. 7 is a schematic diagram of coating a nitride passivation layer on an underlying film according to this application. As shown in FIG. 7, after an underlying superconducting film is coated, a passivation layer may be introduced on a surface of the film to prevent oxidation of the film. A method for growing a nitride passivation layer is simple. However, in subsequent operations, operations such as photoresist spin-coating, exposure, photoresist cleaning, and etching of the underlying film on the underlying film need to be further performed. In this case, since a side wall of an etching groove is not covered by a passivation layer, the side wall of the etching groove is still oxidized. FIG. 8 is a schematic diagram of an oxide layer on a side wall of an etching groove according to this application.

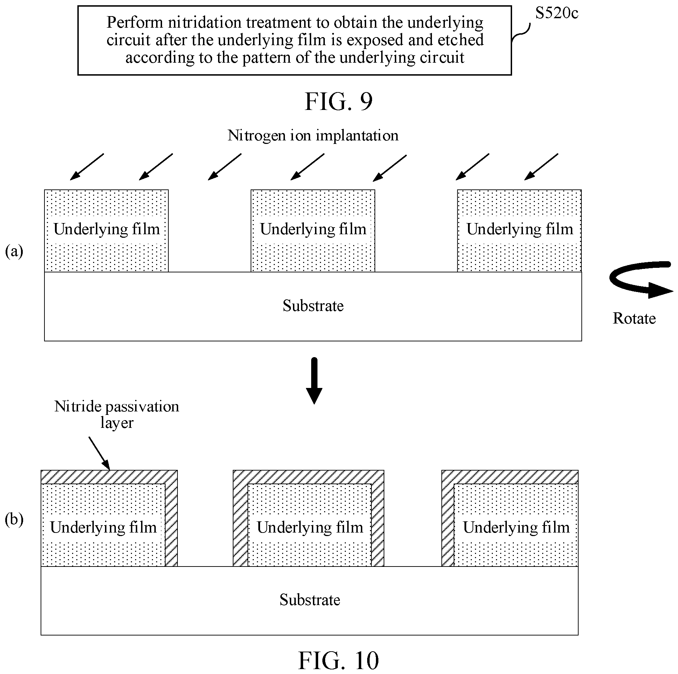

Based on the embodiment shown in FIG. 5, FIG. 9 is a flowchart of a qubit assembly production method according to an embodiment of this application. As shown in FIG. 9, Operation 520 in the embodiment shown in FIG. 5 may be implemented as Operation 520c.

Operation 520c: Perform nitridation treatment to obtain the underlying circuit after the underlying film is exposed and etched according to the pattern of the underlying circuit.

After the underlying film is exposed and etched according to the pattern of the underlying circuit, since the inner wall of the etching groove is not covered by the passivation layer, the inner wall of the etching groove is still oxidized. An oxidation condition of the etching groove may be the schematic diagram of the oxide layer on the side wall of the etching groove shown in FIG. 8.

Therefore, after operations such as photoresist spin-coating, exposure, photoresist cleaning, and etching of the underlying film, the nitridation treatment may be further performed on the surface of the underlying film obtained after the above operations and the side wall of the etching groove, to obtain the underlying circuit having the nitride passivation layer on the surface thereof, thereby avoiding oxidation of the underlying film and the side wall of the etching groove, reducing the generation of the TLS loss, extending the coherence time of the qubit, and improving the coherence of the qubit.

In a possible implementation, the nitridation treatment includes:
placing a first product obtained after the underlying film is exposed and etched in a nitrogen environment and heating the first product to a first temperature.

That is to say, a nitridation treatment method is to place a product obtained after operations such as photoresist spin-coating, exposure, photoresist cleaning, and etching of the underlying film on the underlying film are performed according to the pattern of the underlying circuit into a nitrogen environment, and apply the first temperature to the film, so that the nitrogen reacts with the film to form a nitride, to form a nitride passivation layer that prevents oxidation.

The nitride passivation layer can avoid oxidation of the underlying film and the side wall of the etching groove, reduce the generation of the TLS loss, extend the coherence time of the qubit, and improve the coherence of the qubit.

In a possible implementation, the first temperature is 800 degrees Celsius. In some embodiments, the first temperature may be lower than 800 degrees Celsius, or higher than 800 degrees Celsius. For example, the first temperature may range from 700 degrees Celsius to 900 degrees Celsius.

The temperature applied to the film is generally 800 degrees Celsius or higher, and 800 degrees Celsius is selected in this embodiment of this application. An appropriate environmental temperature can be provided for the reaction of the nitrogen and the underlying film to form a nitride. In addition, anti-oxidation performance of the nitride or the nitride passivation layer can be prevented from being affected by an excessively low environmental temperature.

In a possible implementation, the nitridation treatment includes:
placing a first product obtained after the underlying film is exposed and etched in a nitrogen plasma implantation environment and heating the first product to a second temperature for a specified duration.

To increase the reaction efficiency, another nitridation treatment method is to directly use nitrogen plasma, and a device such as a plasma resist removing machine or a plasma etching machine may be selected.

That is to say, another nitridation treatment method is to place, according to the pattern of the underlying circuit, a product obtained after operations such as photoresist spin-coating, exposure, photoresist cleaning, and etching of the underlying film are performed on the underlying film into a nitrogen plasma implantation environment, so that the nitrogen reacts with the underlying film to form a nitride, to form a nitride passivation layer that prevents oxidation.

The nitride passivation layer can avoid oxidation of the underlying film and the side wall of the etching groove, reduce the generation of the TLS loss, extend the coherence time of the qubit, and improve the coherence of the qubit.

A plasma resist removing machine or a plasma etching machine may be selected as the device.

To improve the implantation efficiency, a specific temperature may also be appropriately applied to the film. In this case, a nitride of a few nanometers may be generated, to form a nitride passivation layer that prevents oxidation.

In a possible implementation, the second temperature is 300 degrees Celsius and the specified duration is 10 minutes. In some embodiments, the second temperature may alternatively be lower than 300 degrees Celsius, or higher than 300 degrees Celsius. For example, the second temperature may range from 250 degrees Celsius to 350 degrees Celsius. In some embodiments, the specified duration may be greater than 10 minutes, or less than 10 minutes. For example, the specified duration may range from 15 minutes to 25 minutes.

In this embodiment of this application, the temperature applied to the film may be heated to about 300 degrees Celsius, and the nitrogen plasma implantation time may be about 10 min. An appropriate environmental temperature and reaction time can be provided for the reaction of the nitrogen and the underlying film to form a nitride. In addition, the anti-oxidation performance of the nitride or the nitride passivation layer can be prevented from being affected by an excessively high or excessively low environmental temperature and excessively short or excessively long reaction time.

In a possible implementation, the nitridation treatment includes:
evaporating a nitride passivation layer on a first product obtained after the underlying film is exposed and etched.

For example, a nitride may be evaporated in an in-situ coating manner to obtain the nitride passivation layer.

For example, the following process may be performed in-situ: cleaning a photoresist and growing a nitride passivation layer on the first product obtained after the first product is obtained by exposing and etching the underlying film. An aluminum film, a niobium film, or a tantalum film may be selected as the underlying film. Since aluminum nitride has a piezoelectric effect and affects subsequent sample measurement, a niobium nitride or a tantalum nitride passivation layer may be selected as the nitride passivation layer.

Alternatively, after the first product is obtained by exposing and etching on the underlying film, a natural oxide layer on a surface of the first product may be cleaned before the nitride passivation layer is evaporated.

Since the TLS loss of the nitride is lower than that of the oxide, the oxidation of the underlying film can be prevented after the nitride passivation layer is grown, and the TLS loss can be reduced. This embodiment of this application can improve the universality of the technical solution, and the technical solution can be widely used for a superconducting film such as an aluminum film, a niobium film, or a tantalum film.

In a possible implementation, before the performing nitridation treatment, the method further includes:
rinsing a surface of the first product, to remove an oxide layer on the surface of the first product.

That is to say, an etched sample needs to be first rinsed, and then the nitridation treatment is performed.

The rinsing may be performed by using hydrofluoric acid, and an objective of the rinsing is to remove the oxide layer on the surface.

Since the nitride is directly generated on the surface of the underlying film, a niobium film or a tantalum film may be used as the underlying film in this case. Specific implementation operations of the foregoing embodiment may be as follows:
First, the etched sample is rinsed by using the hydrofluoric acid to remove the oxide layer on the surface;
then, the etched sample is put into a nitrogen environment, and a temperature is applied to the film, where the temperature is generally 800 degrees Celsius or higher, so that the nitrogen reacts with the film to form the nitride.

To increase the reaction efficiency, nitrogen plasma may alternatively be directly used, and a plasma resist removing machine or a plasma etching machine may be selected as a device. To improve the implantation efficiency, a temperature may be appropriately applied to the film, for example, the film is heated to 300 degrees Celsius, and the implantation time of the nitrogen plasma is 10 min.

In this case, a nitride of a few nanometers may be generated, so that both the surface of the film and the side wall of the etching groove can be well protected.

Based on the solution shown in this embodiment of this application, an improved method is provided: nitrogen ion implantation is performed after etching, where an implantation direction of the nitrogen ion is at a specific angle, and a lower sample needs to be rotated while being implanted, so that the side wall of the etching groove can be implanted with the nitrogen ion. FIG. 10 is a schematic diagram of nitrogen ion implantation according to an exemplary embodiment of this application. As shown in FIG. 10, a part (a) in FIG. 10 is a schematic diagram of a nitrogen ion implantation process, and a part (b) in FIG. 10 is a schematic diagram of generating a nitride passivation layer after nitridation treatment is performed.

In the solution shown in this embodiment of this application, the finally obtained qubit assembly may be the foregoing qubit assembly in FIG. 3. As shown in FIG. 3, the qubit assembly includes the underlying circuit 201 and the qubit 202. The surface of the underlying circuit 201 has the nitride passivation layer 201a, and the inner wall of the etching groove 203 has the nitride passivation layer 203a. The nitride passivation layer 201a and the nitride passivation layer 203a may avoid oxidation of the surface of the underlying circuit, reduce the generation of the TLS loss, and extend the coherence time of the qubit.

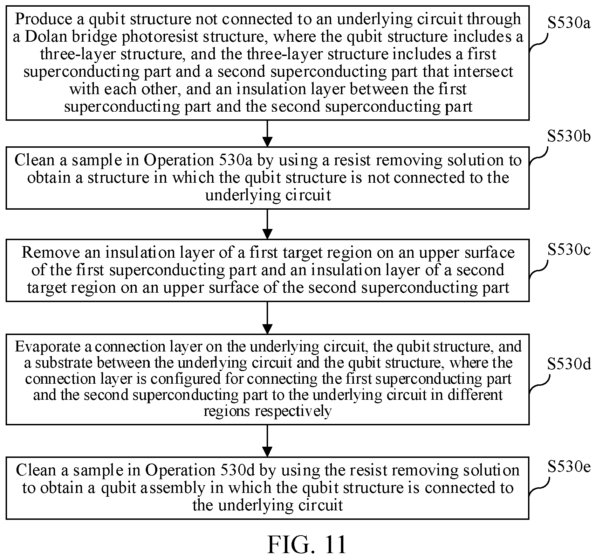

Based on the embodiment shown in FIG. 5, FIG. 11 is a flowchart of a qubit assembly production method according to an embodiment of this application. As shown in FIG. 11, Operation 530 in the embodiment shown in FIG. 5 may be implemented as Operation 530a, Operation 530b, Operation 530c, Operation 530d, and Operation 530e.

Operation 530a: Produce a qubit structure not connected to the underlying circuit through a Dolan bridge photoresist structure; where the qubit structure includes a three-layer structure, and the three-layer structure includes a first superconducting part and a second superconducting part that intersect with each other, and an insulation layer between the first superconducting part and the second superconducting part.

The qubit structure is located in an extension direction of the underlying circuit. That is to say, there is an exposed substrate between the underlying circuit and the qubit structure.

In this embodiment of this application, the qubit structure is a Josephson junction, that is, the qubit structure is a superconductor-insulator-superconductor structure, and the first superconducting part is isolated from the second superconducting part by the insulation layer. The qubit structure may be produced by using the Dolan bridge photoresist structure.

The Dolan bridge photoresist structure is a photoresist structure configured for preparing the Josephson junction.

In a possible implementation, Operation 530a may include the following operations.
(1) Coat a first photoresist on the sample in Operation 520 and perform first baking, where the first photoresist defines the qubit structure.

The first photoresist may be a positive photoresist, a negative photoresist, or a combination of multiple layers of resists.

A first baking temperature is a soft baking temperature of the first photoresist.

For example, a polymethyl methacrylate (PMMA) photoresist may be coated on the sample obtained in Operation 520, and baked at 160 degrees Celsius for 10 min.

(2) Perform exposure, development, and fixing processing on the sample to obtain a Dolan bridge photoresist structure. Different from a conventional structure, the Dolan bridge photoresist structure in this embodiment of this application does not include a part at which the qubit structure is connected to an external circuit waveguide.

An exposure manner may be electron beam exposure.

A developer may be methyl isobutyl ketone (MIBK), or a mixed solution of MIBK and iso-propyl alcohol (IPA).

A fixing solution may be IPA.

For example, in this operation, the sample may be put into an electron beam exposure machine, exposed at a specific dose, and then taken out and placed in a developer in which MIBK:IPA is 1:3 for development, and then placed in IPA for fixing, to obtain the Dolan bridge structure.

(3) Perform double-tilt evaporation on the sample.
a. Vertically evaporate a first superconducting material.
b. Produce an insulation layer.
c. Obliquely evaporate the first superconducting material at a specific tilt angle.

The evaporation method includes electron beam evaporation, magnetron sputtering, thermal evaporation, or the like. A device used may include a double-tilt multi-chamber coating machine.

The insulation layer may be an oxide layer.

A production method of the insulation layer may include dynamic oxygen oxidation in a vacuum chamber, static constant-pressure oxygen oxidation, or the like.

A tilt angle of the oblique evaporation ranges from 20° to 70°.

The first superconducting material may be aluminum, tantalum, niobium, or the like.

For example, in this operation, the sample may be placed into a dual-tilt multi-chamber evaporative coating machine. First, aluminum with a thickness of 30 nm is vertically evaporated, static oxidation is then performed to form an oxide insulation layer on a surface of the aluminum, and then aluminum with a thickness of 30 nm is obliquely evaporated to form the Josephson junction structure.

Operation 530b: Clean the sample in Operation 530a by using a resist removing solution to obtain a structure in which the qubit structure is not connected to the underlying circuit.

In a possible implementation, the resist removing solution may include acetone, n-methylpyrrolidone (NMP), remover PG (an NMP-based dedicated resist removing solution), or the like.

For example, in this operation, the sample obtained in Operation 530a may be placed in the NMP for resist stripping.

Operation 530c: Remove an insulation layer of a first target region on an upper surface of the first superconducting part and an insulation layer of a second target region on an upper surface of the second superconducting part.

The first target region is all or part of a region on the upper surface of the first superconducting part outside a region corresponding to the second superconducting part; and correspondingly, the second target region is all or part of a region on the upper surface of the second superconducting part outside a region corresponding to the first superconducting part.

In this embodiment of this application, since the first superconducting part and the second superconducting part intersect with each other, a part of the upper surface of the first superconducting part is blocked by the second superconducting part, while the remaining part is exposed. Therefore, in the solution shown in this embodiment of this application, an insulation layer of part of the exposed region (that is, the first target region) on the upper surface of the first superconducting part is removed, so that a position of the first superconducting part corresponding to the first target region is not covered by the insulation layer. Correspondingly, in the solution shown in this embodiment of this application, an insulation layer of part of the region (that is, the second target region) on the upper surface of the second superconducting part is further removed.

In a possible implementation, Operation 530c may include the following operations.
(1) Coat a second photoresist on the sample in Operation 530b and perform second baking, where the photoresist defines a part at which the qubit structure is connected to the underlying circuit.

The second photoresist may be a positive photoresist, a negative photoresist, or a combination of multiple layers of resists, or may be a photoresist of the same type as the first photoresist.

A second baking temperature is a soft baking temperature of the second photoresist.

For example, in this operation, an AZ6112 photoresist may be coated on a surface of the sample obtained in Operation 530b, and then baked at 100 degrees Celsius for a period of time.

(2) Perform photoetching, development, and fixing to obtain a corresponding defined pattern, and then use an etching method to remove an insulation layer formed on an exposed part in Operation 530a.

The foregoing photoetching method may include ultraviolet exposure, laser direct writing, or the like.

The developer may be tetramethylammonium hydroxide (TMAH) or a TMAH dilution.

The etching method includes physical and/or reactive etching, and an etching device may include an ion beam etching machine, a dry etching machine, or the like.

For example, in this operation, the sample may be placed in a laser direct writing device to write a pattern, then placed in a TMAH developer with a concentration of 2.38% for development, and then placed in deionised water for fixing to obtain a pattern of a connection region. Subsequently, the sample is placed in an ion beam etching machine and argon ion physical etching is performed on the sample, to remove an oxide insulation layer with a thickness of about 5 nm on a surface of a part of the two layers of aluminum evaporated in Operation 530a exposed on the connection region.

Operation 530d: Evaporate a connection layer on the underlying circuit, the qubit structure, and the substrate between the underlying circuit and the qubit structure, where the connection layer is configured for connecting the first superconducting part and the second superconducting part to the underlying circuit in different regions respectively.

In a possible implementation, a second superconducting material (which may alternatively be another superconducting material other than the second superconducting material) may be evaporated on the sample in Operation 530c, so that the qubit structure is in communication with the underlying circuit.

The evaporation method may include electron beam evaporation, magnetron sputtering, thermal evaporation, or the like.

For example, in this operation, the sample obtained in Operation 530c may be placed into an electron beam evaporation coating machine, and aluminum with a thickness of 100 nm is evaporated on the sample, so that the Josephson junction is connected to the underlying circuit.

Operation 530e: Clean the sample in Operation 530d by using a resist removing solution to obtain a qubit assembly in which the qubit structure is connected to the underlying circuit.

In a possible implementation, the resist removing solution may include acetone, NMP, Remover PG, or the like.

For example, in this operation, the sample obtained in Operation 530d may be placed in the NMP for immersion and stripping, to finally obtain the qubit assembly in which the qubit structure is connected to the underlying circuit.

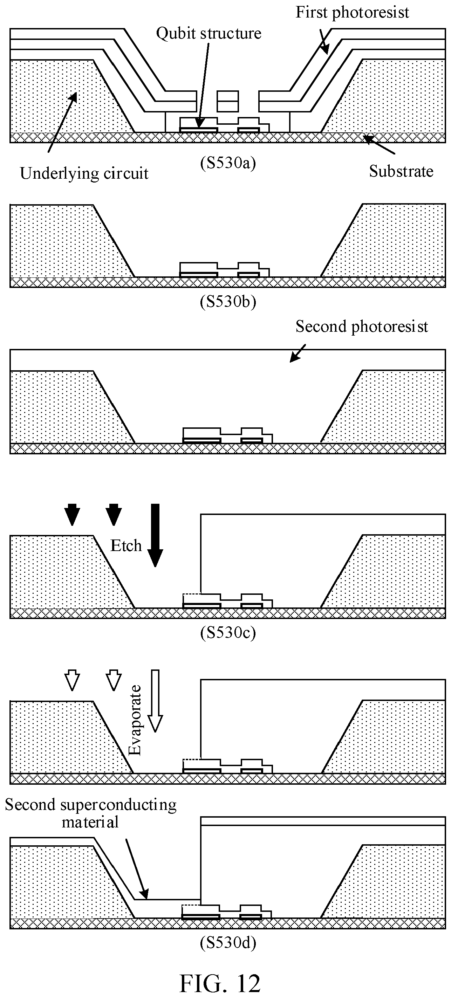

FIG. 12 is a flowchart of preparing a qubit assembly involved in the embodiment shown in FIG. 11. As shown in FIG. 12, after Operation 530a, the surface of the qubit structure in this case is still oxidized because the surface is not covered by a passivation layer. Therefore, nitridation treatment may be performed on the sample obtained in Operation 530a to suppress oxidation of the surface of the qubit structure and avoid impact on characteristics of the subsequent qubit assembly.

In a possible implementation, before Operation 530b, the method further includes: performing nitridation treatment on the sample in Operation 530a.

In a possible implementation, the nitridation treatment includes: placing the sample in Operation 530a in a nitrogen environment and heating the sample to a third temperature.

In a possible implementation, the third temperature is 800 degrees Celsius.

That is to say, a nitridation treatment method is to place a sample obtained after operations such as preparing the qubit structure that is not connected to the underlying circuit through the Dolan bridge photoresist structure into the nitrogen environment and heat the sample to 800 degrees Celsius, so that the nitrogen reacts with the surface of the qubit structure to form a nitride, to form a nitride passivation layer that prevents oxidation. The nitride passivation layer can avoid the oxidation of the surface of the qubit structure, reduce the generation of the TLS loss, extend the coherence time of the qubit, and improve the coherence of the qubit.

In a possible implementation, the nitridation treatment includes: placing the sample in Operation 530a in a nitrogen plasma implantation environment and heating the sample to a fourth temperature for a specified duration.

To increase the reaction efficiency, nitrogen plasma may be directly used, and a plasma resist removing machine or a plasma etching machine may be selected as a device.

In a possible implementation, the fourth temperature is 300 degrees Celsius and the specified duration is 10 minutes.

That is to say, another nitridation treatment method is to place the sample obtained after operations such as preparing the qubit structure that is not connected to the underlying circuit through the Dolan bridge photoresist structure into the nitrogen plasma implantation environment, and heat the sample to 300 degrees Celsius for 10 minutes, so that the nitrogen reacts with the surface of the qubit structure to form a nitride, to form a nitride passivation layer that prevents oxidation. The nitride passivation layer can avoid the oxidation of the surface of the qubit structure, reduce the generation of the TLS loss, extend the coherence time of the qubit, and improve the coherence of the qubit.

In a possible implementation, the nitridation treatment includes: evaporating a nitride passivation layer on the sample in Operation 530a.

That is to say, a nitride may be evaporated in a coating manner to obtain the nitride passivation layer.

For example, a nitride passivation layer is grown on the surface of the qubit structure in situ. A niobium nitride or tantalum nitride passivation layer may be selected as the nitride passivation layer. Since the TLS loss of the nitride is lower than that of the oxide, the oxidation of the surface of the qubit structure can be prevented after the nitride passivation layer is grown, and the TLS loss can be reduced.

After the qubit structure having the nitride passivation layer on the surface is produced, the connection layer in which the qubit structure is connected to the underlying circuit can be further produced. Since the surface of the underlying circuit and the surface of the qubit structure both have a nitride passivation layer, in a subsequent production process, oxidation phenomena of the surface of the underlying circuit and the surface of the qubit structure are suppressed, and the finally obtained qubit assembly can have better coherence.

As shown in FIG. 12, after Operation 530d, a surface of the connection layer in this case is still oxidized because the surface is not covered by a passivation layer. Therefore, nitridation treatment may be performed on the sample obtained in Operation 530d to suppress oxidation of the surface of the connection layer and avoid impact on characteristics of the subsequent qubit assembly.

In a possible implementation, before Operation 530e, the method further includes: performing nitridation treatment on the sample in Operation 530d.

In a possible implementation, the nitridation treatment includes: placing the sample in Operation 530d in a nitrogen environment and heating the sample to a fifth temperature.

In a possible implementation, the fifth temperature is 800 degrees Celsius.

That is to say, a nitridation treatment method is to place the sample obtained after operations such as evaporating the connection layer on the underlying circuit, the qubit structure, and the substrate between the underlying circuit and the qubit structure into a nitrogen environment and heat the sample to 800 degrees Celsius, so that the nitrogen reacts with the surface of the connection layer to generate a nitride, to form a nitride passivation layer that prevents oxidation. The nitride passivation layer can avoid the oxidation of the surface of the connection layer, reduce the generation of the TLS loss, extend the coherence time of the qubit, and improve the coherence of the qubit.

In a possible implementation, the nitridation treatment includes: placing the sample in Operation 530d in a nitrogen plasma implantation environment and heating the sample to a sixth temperature for a specified duration.

To increase the reaction efficiency, another nitridation treatment method is to directly use nitrogen plasma, and a plasma resist removing machine or a plasma etching machine may be selected as a device.

In a possible implementation, the sixth temperature is 300 degrees Celsius and the specified duration is 10 minutes.

That is to say, another nitridation treatment method is to place the sample obtained after operations such as evaporating the connection layer on the underlying circuit, the qubit structure, and the substrate between the underlying circuit and the qubit structure into a nitrogen plasma implantation environment and heat the sample to 300 degrees Celsius for 10 minutes, so that the nitrogen reacts with the surface of the connection layer to generate a nitride, to form a nitride passivation layer that prevents oxidation. The nitride passivation layer can avoid the oxidation of the surface of the connection layer, reduce the generation of the TLS loss, extend the coherence time of the qubit, and improve the coherence of the qubit.

In a possible implementation, the nitridation treatment includes: evaporating a nitride passivation layer on the sample in Operation 530d.

That is to say, a nitride may be evaporated in a coating manner to obtain the nitride passivation layer.

For example, a nitride passivation layer is grown on the surface of the sample obtained after operations such as evaporating the connection layer on the underlying circuit, the qubit structure, and the substrate between the underlying circuit and the qubit structure in situ. A niobium nitride or tantalum nitride passivation layer may be selected as the nitride passivation layer. Since the TLS loss of the nitride is lower than that of the oxide, the oxidation of the surface of the connection layer can be prevented after the nitride passivation layer is grown, and the TLS loss can be reduced.

After the connection layer having the nitride passivation layer on the surface is produced, the qubit assembly in which the qubit structure is connected to the underlying circuit can be further produced. Since the surface of the underlying circuit, the surface of the qubit structure, and the surface of the connection layer all have a nitride passivation layer, in a subsequent production process, oxidation phenomena of the surface of the underlying circuit, the surface of the qubit structure, and the surface of the connection layer are suppressed, and the finally obtained qubit assembly can have better coherence.

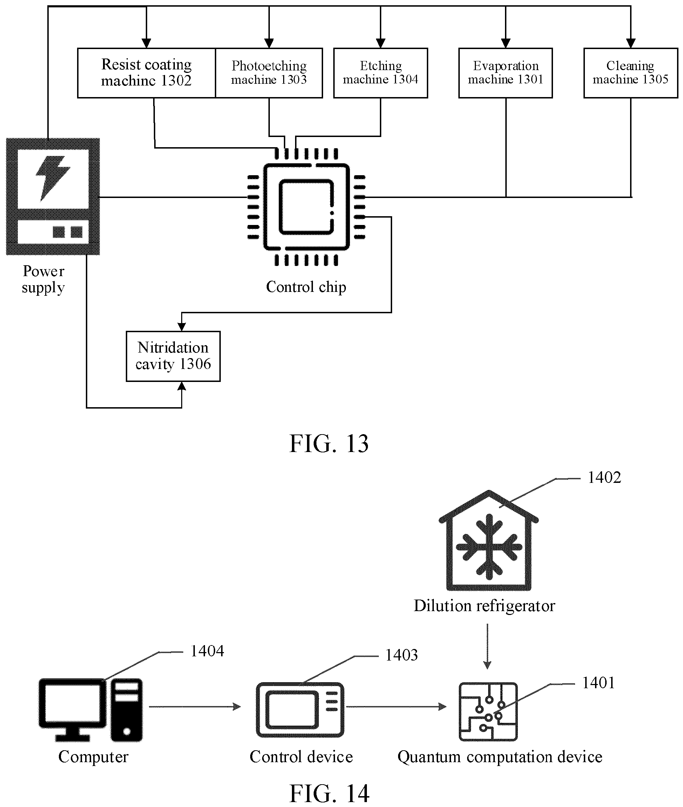

FIG. 13 is a schematic diagram of a chip production system according to an exemplary embodiment of this application. The chip production system can be implemented as a production line device. As shown in FIG. 13, the chip production system includes:
an evaporation machine 1301, a resist coating machine 1302, a photoetching machine 1303, and an etching machine 1304, where
the evaporation machine 1301 is configured to produce an underlying film of a qubit assembly on a substrate;
the resist coating machine 1302, the photoetching machine 1303, and the etching machine 1304 are configured to produce an underlying circuit based on the underlying film, a surface of the underlying circuit having a nitride passivation layer; and
the evaporation machine 1301, the resist coating machine 1302, the photoetching machine 1303, and the etching machine 1304 are further configured to produce, on the substrate, a qubit connected to the underlying circuit, to obtain the qubit assembly.

In a possible implementation, the system further includes a nitridation treatment device configured to perform nitridation treatment to obtain the underlying circuit after the resist coating machine 1302 and the photoetching machine 1303 expose and etch the underlying film according to a pattern of the underlying circuit.

In a possible implementation, the nitridation treatment device includes a nitridation cavity 1306 configured to place a first product obtained after the underlying film is exposed and etched in a nitrogen environment and heat the first product to a first temperature.

In a possible implementation, the first temperature is 800 degrees Celsius.

In a possible implementation, the nitridation treatment device includes a plasma cleaning machine or a plasma etching machine, and the plasma cleaning machine or the plasma etching machine is configured to place a first product obtained after the underlying film is exposed and etched in a nitrogen plasma implantation environment and heat the first product to a second temperature for a specified duration.

In a possible implementation, the second temperature is 300 degrees Celsius and the specified duration is 10 minutes.

In a possible implementation, the nitridation treatment device includes an evaporation machine 1301 configured to evaporate a nitride passivation layer on a first product obtained after the underlying film is exposed and etched.

In a possible implementation, the system further includes:
a cleaning machine 1305, configured to rinse a surface of the first product, to remove an oxide layer on the surface of the first product.

In a possible implementation, the system further includes a nitridation treatment device configured to perform nitridation treatment on the underlying film; and
the resist coating machine 1302, the photoetching machine 1303, and the etching machine 1304 are configured to obtain the underlying circuit by exposing and etching the underlying film obtained after the nitridation treatment according to the pattern of the underlying circuit.

In some embodiments, the production line device further includes a power supply configured to supply power to electrical devices such as a processor, the etching machine 1304, the photoetching machine 1303, and the evaporation machine 1301.

In some embodiments, space connection is implemented between the machines by using a conveyor, or movement of a produced object between the machines is completed based on a robotic arm.

In some embodiments, the production line device further includes a memory. The memory may be configured to store at least one computer instruction. The processor executes the at least one computer instruction, to enable the production line device to perform the foregoing qubit assembly production method.

FIG. 14 is a schematic diagram of a solution application scenario according to an embodiment of this application. As shown in FIG. 14, the application scenario may be a superconducting quantum computing platform. The application scenario includes: a quantum computing component 1401, a dilution refrigerator 1402, a control device 1403, and a computer 1404.

The quantum computing component 1401 is a circuit acting on a physical qubit, and the quantum computing component 1401 may be implemented as a quantum chip such as a superconducting quantum chip located near absolute zero. The quantum chip may be produced through the solution shown in the foregoing embodiments of this application. The dilution refrigerator 1402 is configured to provide an environment of absolute zero for the superconducting quantum chip.

The control device 1403 is configured to control the quantum computing component 1401, and the computer 1404 is configured to control the control device 1403. For example, a programmed quantum program is compiled into an instruction by using software in the computer 1404 and transmitted to the control device 1403 (for example, an electronic/microwave control system), and the control device 1403 converts the instruction into an electronic/microwave control signal and inputs the electronic/microwave control signal into the dilution refrigerator 1402, to control superconducting qubits at a temperature of less than 10 mK. A reading process is opposite to the foregoing description, and a read waveform is transmitted to the quantum computing component 1401.

## Claims

1. A qubit assembly, the qubit assembly comprising:
an underlying circuit and a qubit,
wherein a surface of the underlying circuit is provided with a nitride passivation layer.

2. The qubit assembly according to claim 1, wherein a side surface of an etching groove of the underlying circuit is provided with a nitride passivation layer.

3. The qubit assembly according to claim 1 or 2, wherein
a material of the underlying circuit is a metal selected from niobium, tantalum, or aluminum; and
the nitride passivation layer is a niobium nitride passivation layer, a tantalum nitride passivation layer, or an aluminum nitride passivation layer.

4. The qubit assembly according to any one of claims 1 to 3, wherein the underlying circuit comprises at least one of the following structures:
a resonant cavity, a capacitor, or a transmission line.

5. The qubit assembly according to any one of claims 1 to 4, wherein a thickness of the nitride passivation layer ranges from 5 nanometers to 10 nanometers.

6. A qubit assembly production method, the method comprising:
producing an underlying film of a qubit assembly on a substrate;
producing an underlying circuit based on the underlying film, a surface of the underlying circuit being provided with a nitride passivation layer; and
producing, on the substrate, a qubit connected to the underlying circuit, to obtain the qubit assembly.

7. The method according to claim 6, wherein the producing an underlying circuit based on the underlying film comprises:
performing exposing and etching on the underlying film according to a pattern of the underlying circuit to obtain a first product, and performing nitridation treatment on the first product to obtain the underlying circuit.

8. The method according to claim 7, wherein the nitridation treatment comprises:
placing the first product in a nitrogen environment and heating the first product to a first temperature.

9. The method according to claim 8, wherein the first temperature is 800 degrees Celsius.

10. The method according to claim 7, wherein the nitridation treatment comprises:
placing the first product in a nitrogen plasma implantation environment and heating the first product to a second temperature for a specified duration.

11. The method according to claim 7, wherein the nitridation treatment comprises:
evaporating a nitride passivation layer on the first product.

12. The method according to any one of claims 7 to 11, before the performing nitridation treatment, further comprising:
rinsing a surface of the first product, to remove an oxide layer on the surface of the first product.

13. The method according to any one of claims 6 to 12, wherein the producing an underlying circuit based on the underlying film comprises:
performing nitridation treatment on the underlying film, to obtain a treated product; and
performing exposing and etching, according to a pattern of the underlying circuit, on the treated product, to obtain the underlying circuit.

14. A quantum chip, the quantum chip comprising the qubit assembly according to any one of claims 1 to 5.

15. A chip production system, the system comprising: an evaporation machine, a resist coating machine, a photoetching machine, and an etching machine;
the evaporation machine being configured to produce an underlying film of a qubit assembly on a substrate;
the resist coating machine, the photoetching machine, and the etching machine being configured to produce an underlying circuit based on the underlying film, a surface of the underlying circuit being provided with a nitride passivation layer; and
the evaporation machine, the resist coating machine, the photoetching machine, and the etching machine being further configured to produce, on the substrate, a qubit connected to the underlying circuit, to obtain the qubit assembly.

16. The system according to claim 15, wherein the resist coating machine, the photoetching machine, and the etching machine are configured to perform exposing and etching on the underlying film according to a pattern of the underlying circuit to obtain a first product, and perform nitridation treatment on the first product to obtain the underlying circuit.

17. The system according to claim 16, wherein the nitridation treatment comprises:
placing the first product in a nitrogen environment and heating the first product to a first temperature.

18. The system according to claim 17, wherein the first temperature is 800 degrees Celsius.

19. The system according to claim 16, wherein the nitridation treatment comprises:
placing the first product in a nitrogen plasma implantation environment and heating the first product to a second temperature for a specified duration.

20. The system according to claim 16, wherein the nitridation treatment comprises:
evaporating a nitride passivation layer on the first product.
